# EUROPEAN PATENT SPECIFICATION

(11) **EP 1 883 117 B1**
(45) Date of publication and mention of the grant of the patent: **19.01.2011**
(21) Application number: 07014439.9
(22) Date of filing: 23.07.2007
(51) Int. Cl.: H01L 31/0224, H01L 31/18

(54) **Photovoltaic module and fabrication method thereof**
Photovoltaisches Modul and Herstellungsverfahren dafür
Module photovoltaïque et son procédé de fabrication

(30) Priority: 28.07.2006 JP 2006205833
(43) Date of publication of application: 30.01.2008
(73) Proprietor: Sanyo Electric Co., Ltd., Osaka 570-8677 (JP)
(72) Inventor: Terada, Norihiro, Izumiootsu-city, Osaka 595-0025 (JP); Ono, Masayoshi, Sumoto-city, Hyogo 656-0085 (JP); Okamoto, Shingo, Toyonaka-city, Osaka 560-0085 (JP)
(74) Representative: Merkle, Gebhard

(56) References cited:
- EP-A- 0 855 749
- DE-A1- 4 143 083
- US-A- 5 759 219
- ZHAO J ET AL: "22.3% EFFICIENT SILICON SOLAR CELL MODULE" CONFERENCE RECORD OF THE 25TH. IEEE PHOTOVOLTAIC SPECIALISTS CONFERENCE 1996. WASHINGTON, MAY 13 - 17, 1996, CONFERENCE RECORD OF THE IEEE PHOTOVOLTAIC SPECIALISTS CONFERENCE, NEW YORK, IEEE, US, vol. CONF. 25, 13 May 1996 (1996-05-13), pages 1203-1206, XP000897043 ISBN: 0-7803-3167-2

## Description

### BACKGROUND OF THE INVENTION

### TECHNICAL FIELD

The present invention relates to a photovoltaic element and a fabrication method thereof.

### DESCRIPTION OF RELATED ART

A photovoltaic element is known which has a translucent conductive film, such as of ITO (indium tin oxide), formed on a surface of a photoelectric conversion layer for collection of a current generated in the conversion layer, and a collector electrode formed on the conductive film for passing the current to the outside. As the collector electrode, a finger electrode configured to extend from one end of an element surface to the other end thereof and comprising plural fingers spaced apart at regular intervals and a bus bar electrode integrally formed with the finger electrode for further collection of the current collected in the finger electrode are generally formed.

A tab electrode is generally mounted to the collector electrode for carrying the current collected in the collector electrode to the outside. For example, in the case where a solar cell (photovoltaic) module is fabricated via arrangement of plural photovoltaic elements, a tab electrode comprising a metal foil such as a copper foil is generally soldered at its one end to a collector electrode of one photovoltaic element and at its other end to a back electrode of the neighboring other photovoltaic element so that the plural photovoltaic elements are connected in series.

Japanese Patent Laid-Open No. 2004-228333 discloses a photovoltaic element structure in which a tab electrode is mounted to a collector electrode. Japanese Patent Laid-Open No. 2004-228333 also discloses provision of a coating film on a light receiving surface of the photovoltaic element for protection of its surface.

However, when a high-melting solder is used to mount a tab electrode to a collector electrode, a photovoltaic element must be heated to a high temperature. This produces a mechanical stress in the photovoltaic element to result in the occurrence of warpage or fracture of the element, which has been a problem. In order to avoid occurrence of warpage or fracture, a low-melting solder may be used. However, it generally lowers mounting strength between the tab and collector electrodes to problematically reduce reliability or an output. Also, there has been a possibility of water intrusion into a region between the tab and collector electrodes, regardless of the melting point of the solder used. If it actually occurs, the mounting strength between the tab and collector electrodes is lowered to reduce reliability.

Japanese Patent Laid-Open No. Hei 8-174264 discloses an example of solder paste which can be employed in the present invention as a thermosetting conductive solder paste. Document US 5,759,291 discloses a photovoltaic cell with electrodes.

### SUMMARY OF THE INVENTION

It is an object of the present invention to provide a photovoltaic module, formed with elements, which allows use of a low-melting solder and can suppress reduction of reliability or output due to mechanical stress or water intrusion, as well as providing a fabrication method of the element.

The photovoltaic element of the present invention has a photoelectric conversion layer and a collector electrode provided on at least one surface of the photoelectric conversion layer. Characteristically, a collector electrode covering layer is provided which covers a surface of the collector electrode, a tab electrode for electrical connection to an external electrode is provided on a top surface of the collector electrode through the collector electrode covering layer, a portion of the collector electrode covering layer that lies between the tab and collector electrodes comprises a solder layer, and another portion of the collector electrode covering layer that covers a lateral surface of the collector electrode comprises a thermosetting resin layer.

In the present invention, in the collector electrode covering layer which covers a surface of the collector electrode, its portion that lies between the tab and collector electrodes comprises a solder layer and its another portion that covers a lateral surface of the collector electrode comprises a thermosetting resin layer. Accordingly, the solder layer is integrally formed with the thermosetting resin layer, so that the mounting strength between the tab and collector electrodes can be reinforced by the thermosetting resin layer. This accordingly permits a solder, if low in melting point, to mount the tab electrode to the collector electrode without reduction of mounting strength. Therefore, an output reduction of the photovoltaic element due to mechanical stress or others can be suppressed.

In the present invention, the collector electrode is provided on at least one surface of the photoelectric conversion layer, preferably on each surface thereof.

Also, an interface between the collector electrode and the underlying layer can be covered at its periphery with the thermosetting resin layer. This prevents water intrusion or the like and accordingly suppresses deterioration of output characteristics of the photovoltaic element due to water intrusion or the like.

There also exists a photovoltaic element construction in which a translucent conductive film is provided on a light-receiving side of the photoelectric conversion layer. Hence, also in the present invention, a translucent conductive film may be provided on the photoelectric conversion layer. In this case, the collector electrode is provided on the translucent conductive film.

A coating film may be provided on the photoelectric conversion layer or translucent conductive film. In the case where such a coating film is provided, the thermosetting resin layer is preferably positioned between the collector electrode and an end of the coating film. Accordingly, the end of the coating film is preferably spacedabout 0.5 - 3mm (more preferably about 1 - 2 mm) from the lateral side of the collector electrode. The coating film may partly contact with the collector electrode. Such a coating film also functions as a protective film that protects a surface of the photovoltaic element. The coating film can be illustrated by a resin coating film comprised of a resin.

In the present invention, the tab electrode preferably has a width sufficient to cover the thermosetting resin layer located outwardly of the lateral surface of the collector electrode. Such coverage of the thermosetting resin layer with the tab electrode protects the thermosetting resin layer from deterioration and discoloration by ultraviolet irradiation. Preferably, the tab electrode is configured to cover the thermosetting resin layer on at least a light-receiving surface of the photoelectric conversion layer, which locates on a primary light-receiving side, among both surfaces thereof. In this case, the coating film is preferably provided.

In the present invention, the collector electrode may comprises a bus bar electrode. That is, in the case where a finger electrode and a bus bar electrode are provided as the collector electrode, the collector electrode covering layer may be provided on the bus bar electrode.

As described above, a low-melting solder can be used in the present invention. Accordingly, a solder layer in the present invention can be a low-melting solder layer such as of an Sn-Bi alloy.

The fabrication method of the present invention can be utilized to fabricate the photovoltaic element of the present invention. Characteristically, the method comprises the steps of applying a thermosetting conductive solder paste onto a collector electrode to form a solder paste layer; providing a tab electrode on the solder paste layer; and heating the solder paste layer while the tab electrode is provided thereon so that a solder component contained in the solder paste layer melts and coalesces between the tab electrode and the collector electrode to form the solder layer and a thermosetting resin contained in the solder paste layer coalesces in a region on the lateral surface of the collector electrode to form the thermosetting resin layer, whereby the solder layer and the thermosetting resin layer constitutes the collector electrode covering layer on the surface of the collector electrode.

In the fabrication method of the present invention, the thermosetting conductive solder paste is applied onto the collector electrode to form the solder paste layer. The thermosetting conductive solder paste may contain a solder component, thermosetting resin, flux, hardener, solvent and others. One example of such a paste is disclosed in Japanese Patent Laid-Open No. Hei 8-174264, which contains a powdered solder, a thermosetting resin having a function to remove an oxide film (i.e., having a flux characteristic as well), a hardener, a solvent and others. Preferably, solders having melting points of not exceeding 220 °C, more preferably those having melting points of not exceeding 200 °C, e.g., an SnBi alloy, are used as the solder component, as described above. Examples of other solder components include SnAgCu, SnAgCuB, SnAgCuIn, SnAgCuSb, SnAgCuBiIn, SnAgBiIn, SnZnBi and SnBiAg. These can be suitably used without any particular limitation. The thermosetting resin can be illustrated by epoxy resins. Carboxylated thermosetting resins such as carboxylated epoxy resins may be suitably used.

In the present invention, after the solder paste layer is formed on the collector electrode in the manner as described above, the tab electrode is provided on the solder paste layer. With the tab electrode being placed thereon, the solder paste layer is subsequently heated so that the solder component contained in the solder paste layer melts and coalesces between the tab electrode and the collector electrode to form the solder layer. At the same time, the thermosetting resin contained in the solder paste layer forms the thermosetting resin layer on the lateral surface region of the collector electrode. Hence, heating results in the simultaneous formation of the solder layer and the thermosetting resin layer respectively on the top surface region and lateral surface region of the collector electrode. The thus-formed solder layer and thermosetting resin layer constitutes the collector electrode covering layer in the present invention.

In accordance with the fabrication method of the present invention, formation of the solder paste layer on the collector electrode using the thermosetting conductive solder paste leads to the provision of the collector electrode covering layer as a result of integral formation of the solder layer and the thermosetting resin layer which overlie the top surface region and the lateral surface region of the collector electrode, respectively. Because the solder layer is integrally formed with the thermosetting resin layer, as described above, it is firmly held on the collector electrode. Therefore, the solder layer, even if formed using a low-melting solder component, can be firmly connected to the collector electrode with the aid of the thermosetting resin layer.

Also in the present invention, the translucent conductive film and the collector electrode may be sequentially formed on the photoelectric conversion layer. As the translucent conductive film, a thin film of a translucent metal oxide such as an ITO (indium tin oxide) or IZO (indium zinc oxide) can be formed.

Also, the present invention may further include a step of forming a coating film on the translucent conductive film. When the solder paste layer is heated to form the thermosetting resin layer, such a coating film stops wetting and spreading of the thermosetting resin. Accordingly, the provision of the coating film forces the thermosetting resin layer to lie between the collector electrode and the end of the coating film. This is conceivably because the thermosetting resin in the solder paste layer has an affinity for the translucent conductive film but has no affinity for the coating .film. Hence, the coating film preferably has a nature of repelling the thermosetting resin in the solder paste layer. Because the provision of the coating film having such a nature allows the thermosetting resin in the solder paste layer to form the thermosetting resin layer selectively in a predetermined section, the thermosetting resin can be efficiently utilized as an adhesive.

The coating film formed in the present invention can be illustrated by a resin coating film containing an acrylic resin as a resin component. Those containing at least one selected from silicon oxide, aluminum oxide, magnesium oxide, titanium oxide and zinc oxide, as an additive, are preferably used.

In accordance with the present invention, a photovoltaic element can be fabricated which allows use of a low-melting solder and suppresses reduction of an output due to mechanical stress, water intrusion or the like.

### BRIEF DESCRIPTION OF THE DRAWINGS

Figure 1 is a plan view which shows an embodiment of a photovoltaic element in accordance with the present invention;
Figure 2 is a sectional view taken along the line 30-30 of Figure 1;
Figure 3 is a plan view which shows a photovoltaic element in its condition subsequent to formation of a resin coating layer;
Figure 4 is a schematic view which shows plural photovoltaic elements connected in series by tab electrodes;
Figure 5 is a sectional view which shows a construction of a photovoltaic module including photovoltaic elements in accordance with an embodiment of the present invention; and
Figure 6 is a schematic sectional view which shows an interface between a thermosetting resin layer and a resin coating layer and its vicinity in an enlarged fashion.

### DESCRIPTION OF THE PREFERRED EMBODIMENTS

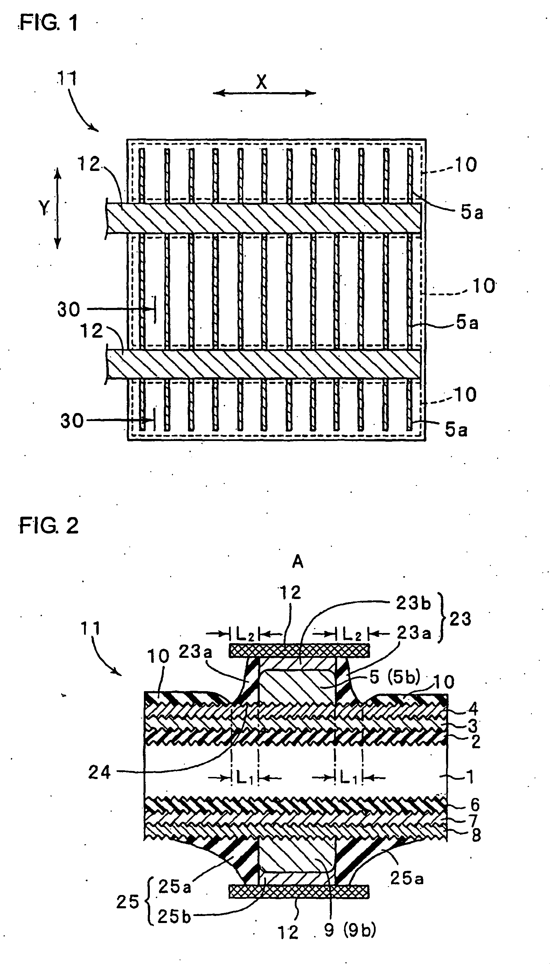

Figure 1 is a plan view illustrating an embodiment of a photovoltaic element in accordance with the present invention and Figure 2 is a sectional view taken along the line 30-30 of Figure 1.

As shown in Figure 2, an embodiment of a photovoltaic element 11 in accordance with the present invention includes an n-type single crystal silicon substrate 1 having a thickness of about 140 µm - about 300 µm, a substantially intrinsic i-type amorphous silicon layer 2 formed on a top surface (light-receiving surface) of the silicon substrate 1 and having a thickness of about 5 nm - about 20 nm, and a p-type amorphous silicon layer 3 formed on the i-type amorphous silicon layer 2 and having a thickness of about 5 nm - about 20 nm. Formed on the p-type amorphous silicon layer 3 is an ITO translucent conductive film 4 having a thickness of about 30 nm - about 150 nm.

A collector electrode 5 is formed on a predetermined region of the translucent conductive film 4 by thermosetting a silver (Ag) paste. As shown in Figure 1, this collector electrode 5 comprises plural finger electrodes 5a spaced apart at regular intervals in the X direction and a bus bar electrode 5b configured to extend in the X direction. Those finger electrodes 5a extend in the Y direction in parallel to each other. The bus bar electrode 5b further collects the current collected by the finger electrodes 5a.

The finger electrode 5a and the bus bar electrode 5b have a thickness of about 10 µm - about 100 µm. Also, the bus bar electrode 5b has a width of about 1 nm- about 3 nm (2 nm, for example). The surface side (A side in Figure 2) on which the collector electrode 5 is formed is a light incident side of the photovoltaic element 11.

As also shown in Figure 2, a substantially intrinsic i-type amorphous silicon layer 6 having a thickness of about 5 nm - about 20 nm and an n-type amorphous silicon layer 7 having a thickness of about 5 nm - about 20 nm are sequentially formed on a bottom surface of the n-type single crystal silicon substrate 1. A translucent conductive film 8 comprised of an ITO film having a thickness of about 30 nm - about 150 nm is formed on the n-type amorphous silicon layer 7. Similar to the top collector electrode 5, a back collector electrode 9 is formed on the translucent conductive film 8. The back collector electrode 9 also comprises finger electrodes and a bus bar electrode, as similar to the top collector electrode 5.

Both the top and bottom surfaces of the n-type single crystal silicon substrate 1 have a texture structure (irregular profile). Accordingly, the similar irregular surface profile is succeeded to the i-type amorphous silicon layers 2 and 6, p-type amorphous silicon layer 3, n-type amorphous silicon layer 7 and translucent conductive films 4 and 8, respectively formed on the top and bottom surfaces.

In this embodiment, the photoelectric conversion layer consists of the n-type single crystal silicon substrate 1, i-type amorphous silicon layers 2 and 6, p-type amorphous silicon layer 3 and n-type amorphous silicon layer 7

The i-type amorphous silicon layers 2 and 6, p-type amorphous silicon layer 3 and n-type amorphous silicon layer 7 are formed by an RF plasma CVD process.

The translucent conductive films 4 and 8 are formed by a magnetron sputtering process.

The collector electrodes 5 and 9 are formed by a screen printing process using an Ag paste.

As shown in Figure 2, a resin coating film 10 is formed on the translucent conductive film 4 of the light incident side. The resin coating film 10 is formed from an acrylic resin containing silicon oxide as an additive.

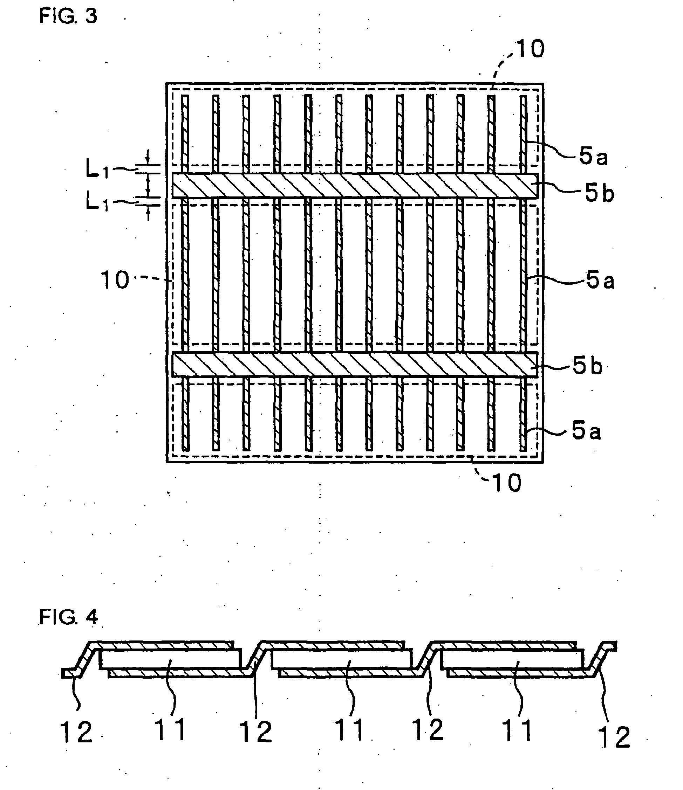

Figure 3 is a plan view which shows the photovoltaic element in condition subsequent to formation of the resin coating film 10. As shown in Figures 2 and 3, the resin coating film 10 is not in contact with a lateral surface of each side of the bus bar electrode 5b and spaced a distance L₁ (about 1 nm - about 2 nm) from the lateral surface of the bus bar electrode 5. This leaves a region 24 on a surface of the translucent conductive film 4 outside the lateral surface of the bus bar electrode 5, where the resin coating film 10 is not deposited. Accordingly, a width of the region 24 is equal to the distance L₁. As shown in Figure 3, the resin coating layer 10 is deposited such that it covers regions over the finger electrodes 5a.

The resin coating film 10 has a function to prevent wetting and spreading of a thermosetting resin layer 23a which is formed when a solder paste layer deposited via application of the below-described thermosetting conductive solder paste is thermoset. Another function thereof is to protect a surface of the translucent conductive film 4 from damage. A further function thereof is to stop water or the like from contacting with a surface of the translucent conductive film 4.

The resin coating film 10 is formed by applying an acrylic resin containing silicon oxide as an additive such as by an offset rotary printing process or a spray process using a mask, and then heating the applied resin at about 150 °C for 150 seconds to harden it.

As shown in Figure 2, a collector electrode covering layer 23 is formed on a surface of the bus bar electrode 5b. This collector electrode covering layer 23 is constituted by a solder layer 23 b formed on a top surface of the bus bar electrode 5b and a thermosetting resin layer 23a formed in a region on a lateral surface of the bus bar electrode 5b. One end of the tab electrode 12 is positioned, through the collector electrode covering layer 23, on the top surface of the bus bar electrode 5b. The end of the tab electrode 12 is electrically connected to the bus bar electrode 5b through the solder layer 23b. The other end of the tab electrode 12 is connected to a back electrode of the neighboring photovoltaic element 11, as shown in Figure 4, whereby plural photovoltaic elements 11 are connected in series.

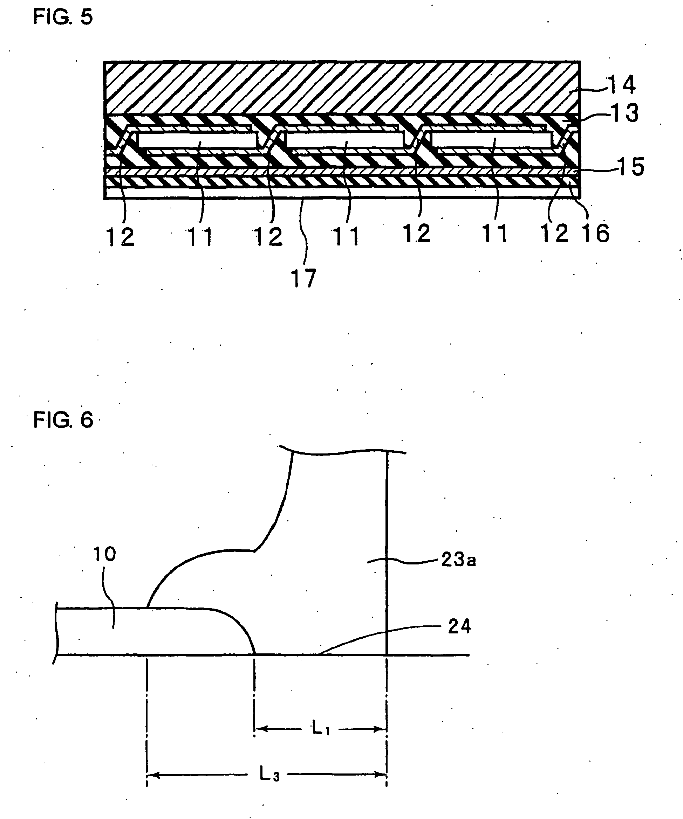

The tab electrode 12 has a width portion that extends outwardly from each lateral surface of the bus bar electrode 5b a distance of L₂. Preferably, this distance L₂ is made about comparable to or longer than the distance L₁ so that the tab electrode can cover the thermosetting resin layer 23a. As shown in Figure 6, in the case where the thermosetting resin layer 23a extends beyond the distance L₁, which is the width of the region 24, to have a width of a distance L₃, the distance L₂, which is a width of a projecting portion of the tab electrode 12, is preferably made about comparable to or longer than the distance L₃. Dimensioning the end of the tab electrode 12 to have a width enough to cover the thermosetting resin layer 23a prevents deterioration and discoloration of the thermosetting resin layer 23a by an ultraviolet light or the like. In view of accuracy and others of a fabrication process, the distance L₂ is preferably set larger than the distance L₃.

In Figure 6, the thermosetting resin layer is shown to extend over the end of the resin coating film 10. This case is considered to occur when the thermosetting resin is large in amount, for example. However, within the variation of amount in the fabrication, the provision of the coating film having a nature of repelling the thermosetting resin minimizes this extension and enables it to stop at the end of the coating film.

The configuration described in the present invention as "the thermosetting resin is positioned between the collector electrode and the end of the coating film" encompasses the case shown in Figure 6.

On the back side of the photovoltaic element 11, the other end of the tab electrode 12 is connected, through a solder layer 25b, to a bus bar electrode 9b of the back side, as shown in Figure 2. Also on the back side, a collector electrode covering layer 25 is constituted by the solder layer 25b formed in a region on the bus bar electrode 9b and a thermosetting resin layer 25a formed in a region on a lateral surface of the bus bar electrode 9b.

Due to the presence of the resin coating film 10, the thermosetting resin layer 23a of the top side is restrained from wetting and spreading and accordingly confined between the bus bar electrode 5b and the end of the resin coating film 10, as shown in Figure 2. On the other hand, the thermosetting resin layer 25a of the back side is flared because of the absence of the resin coating film 10.

The bus bar electrode 9b is electrically connected, through the solder layer 25b, to the other end of the tab electrode 12.

The solder layers 23b and 25b have respective lateral sides integrally formed with the thermosetting resin layers 23a and 25a. Accordingly, they are bonded to the bus bar electrodes 5b and 9b, respectively, with high bonding strength. This allows use of a low-melting solder component, such as an Sn-Bi solder, for formation of the solder layers 23b and 25b.

Also, the thermosetting resin layer 23a can enhance the bonding strength between the tab electrode 12 and the bus bar electrode 5b.

Also, the thermosetting resin layer 23a can prevent water intrusion into an interface between the translucent conductive film 4 and the bus bar electrode 5b, because it covers an entire lateral surface of the bus bar electrode 5b. Likewise, the thermosetting resin layer 25a can prevent water intrusion into an interface between the translucent conductive film 8 and the bus bar electrode 9b, because it covers an entire lateral surface of the bus bar electrode 9b. Accordingly, such photovoltaic elements, when installed outdoors in the form of a photovoltaic element, can prevent reduction in reliability and output of the module due to water intrusion and mechanical stress that occurs as the temperature rises and drops.

The collector electrode covering layer 23 consisting of the solder layer 23b and the thermosetting resin layer 23a, as well as the collector electrode covering layer 25 consisting of the solder layer 25b and the thermosetting resin layer 25a, can be formed in the manner as described below.

That is, a thermosetting conductive solder paste (product of Tamura Kaken Corp., product name "TCAP-5401-11") is applied onto the bus bar electrodes 5b or 9b as by a dispenser, screen printing or offset printing process. The thermosetting conductive solder paste contains Sn-Bi solder particles, a thermosetting resin (epoxy resin), a hardener, a flux and others. The solder particles are contained in the amount of about 78 % by weight and the epoxy resin is contained in the amount of about 18 % by weight.

By the application of the thermosetting conductive solder paste onto the bus bar electrodes 5b or 9b, as described above, a solder paste layer is formed. Subsequently, a tab electrode comprised of a copper foil is placed on the solder paste layer. With this arrangement, they are heated at 160 °C for 360 seconds. Since a melting point of the Sn-Bi solder in the solder paste layer is 139 °C, such heating causes the Sn-Bi solder to melt. The melted solder component coalesces in a region between the copper foil tab electrode 12 and the bus bar electrode 5b or 9b made of an Ag paste to form the solder layer 23b or 25b. Concurrently, the thermosetting resin contained in the solder paste layer 10 bleeds out over a region on a lateral surface of the bus bar electrode 5b or 9b to form the thermosetting resin layer 23a or 25a. In the solder layer 23b or 25b, the Sn-Bi solder is alloyed with the bus bar electrode 5b or 9b as well as with the copper foil tab electrode 12 by the action of the flux contained in the solder paste layer to create electrical connection therebetween.

By the above-outlined process, the photovoltaic elements 11 can be connected in series by the tab electrodes 12, as shown in Figure 4.

In the above-described process, heating may be effected to such a degree that the solder paste layer is provisionally hardened to a strength sufficient to endure transport to the subsequent sealing step. After provisional hardening, it can be finally hardened in the sealing process (laminate curing). For example, the solder paste layer may be provisionally hardened by heating at 160°C -200°C for an approximate period of several seconds - 30 seconds and then finally hardened in the sealing process (laminate curing) by heating at 140 °C - 160 °C for an approximate period of 15 minutes - 40 minutes. In this case, because final hardening can be effected by heating in the sealing process (laminate curing), the time required for provisional hardening can be shortened. Accordingly, an overall process time can be shortened.

Figure 5 is a sectional view which shows a construction of a photovoltaic module including plural photovoltaic elements 11 connected in series by the tab electrodes 12. As shown in Figure 5, in the photovoltaic module, the tab electrodes 12 connect plural photovoltaic elements 11 to each other. Such photovoltaic elements 11 connected to each other by the tab electrodes 12 are sealed by a filler 13 composed of anEVA (ethylene vinyl acetate) resin. Also, a surface protective member 14 comprising a transparent glass is provided on a top surface (on the light incident side) of the filler 13. Also, a PET (polyethylene terephthalate) film 15, an aluminum foil 16 and a PET film 17 are sequentially placed on a bottom surface of the filler 13 that seals the plural photovoltaic elements 11.

In the embodiment of the photovoltaic element according to the present invention, the thermosetting resin layer is formed integrally with the solder layer to cover the bus bar electrode serving as the collector electrode, as described above. Accordingly, in the case where a photovoltaic module incorporating such photovoltaic elements is installed outdoors, even if any photovoltaic element is subjected to a mechanical stress due to rise and drop of temperature, its construction in the vicinity of the collector electrode can be prevented from destruction. This suppresses reduction in reliability and output of the module. Also, water intrusion into the vicinity of the collector electrode can be prevented. Accordingly, the output decline of the module due thereto can also be suppressed.

In the above embodiment, the n-type single crystal silicon substrate is used as a substrate for the photovoltaic element. However, a p-type single crystal silicon substrate can be used alternatively. In this case, an i-type amorphous silicon layer and an n-type amorphous silicon layer are formed on the top side, while an i-type amorphous silicon layer and a p-type amorphous silicon layer are formed on the back side. Further, an n-type or p-type crystalline semiconductor substrate may be doped at its surface with a p-type or n-type dopant to form an pn junction, resulting in the provision of the photoelectric conversion layer. The present invention can also be applied to other types of photovoltaic elements.

## Claims

1. A solar cell module including a plurality of photovoltaic elements (11) connected to each other by a tab electrode (12), said each photovoltaic element (11) having a photoelectric conversion layer and a collector electrode (5) provided on at least one surface of the photoelectric conversion layer, wherein in said photovoltaic element (11) a collector electrode covering layer (23) is provided for covering a surface of the collector electrode (5) provided on said at least one surface of the photoelectric conversion layer; a tab electrode (12) for electrical connection to an exterior electrode is provided, through said collector electrode covering layer (23), on a top surface of the collector electrode (5); **characterised in that** a portion of the collector electrode covering layer (23) that lies between said tab electrode (12) and the collector electrode (5) comprises a solder layer (23b); and another portion of the collector electrode covering layer (23) that covers a lateral surface of the collector electrode (5) comprises a thermosetting resin layer (23a).

2. The solar cell module as recited in claim 1, **characterized in that** a coating film (10) is provided on said photoelectric conversion layer, and said thermosetting resin layer (23a) lies between the collector electrode (5) and an end of said coating film (10).

3. The solar cell module as recited in claim 2, **characterized in that** a translucent conductive film (4) is provided on the photoelectric conversion layer, and the coating film (10) and the collector electrode (5) are provided on said translucent conductive film (4).

4. The solar cell module as recited in claim 2 or 3, **characterized in that** the coating film (10) is a resin coating film.

5. The solar cell module as recited in any one of claims 1-4, **characterized in that** the tab electrode (12) has a width sufficient to cover the thermosetting resin layer (23a) located outwardly of said lateral side of the collector electrode (5).

6. The solar cell module as recited in any one of claims 1-5. **characterized in that** the collector electrode (5) is a bus bar electrode (5b).

7. The solar cell module as recited in any one of claims 1-6, **characterized in that** the solder layer (23b) is formed from an SnBi alloy.

8. A method for fabrication of the solar cell module recited in any one of claims 1 - 7, **characterized in that** it comprises the steps of: applying a thermosetting conductive solder paste onto the collector electrode (5) to form a solder paste layer; providing the tab electrode (12) on said solder paste layer; and heating the solder paste layer while the tab electrode (12) is placed thereon so that a solder component contained in the solder paste layer melts to form the solder layer (23b) between the tab electrode (12) and the collector electrode(5) and a thermosetting resin contained in the solder paste layer forms the thermosetting resin layer (23a) in a region on the lateral surface of the collector electrode (5), whereby the solder layer (23b) and the thermosetting resin layer (23a) constitutes the collector electrode covering layer (23) on the surface of the collector electrode (5).

9. The method for fabrication of the solar cell module as recited in claim 8, **characterized in that** it further comprises the step of forming the coating film (10) on the photoelectric conversion layer, whereby when the solder paste layer is heated to form the thermosetting resin layer (23a), the coating film (10) restrains the thermosetting resin from wetting and spreading so that the thermosetting resin layer (23a) lies between the collector electrode (5) and the end of the coating film (10).

10. The method for fabrication of the solar cell module as recited in claim 9, **characterized in that** it further comprises the step of forming the translucent conductive film (4) on the photoelectric conversion layer, and that the step of forming the coating film (10) is the step of forming the coating film (10) on the translucent conductive film (4).

## Patentansprüche

1. Solarzellenmodul, umfassend:
eine Vielzahl von photovoltaischen Elementen (11), die miteinander durch eine Streifenelektrode (12) verbunden sind, wobei jedes dieser photovoltaischen Elemente (11) eine photoelektrische Umwandlungsschicht und eine auf mindestens einer Oberfläche der photoelektrischen Umwandlungsschicht vorgesehene Kollektorelektrode (5) aufweist,
wobei in diesem photovoltaischen Element (11) eine Kollektorelektrodenabdeckschicht (23) vorgesehen ist, um eine Oberfläche der Kollektorelektrode (5) zu bedecken, die auf dieser mindestens einen Oberfläche der photoelektrischen Umwandlungsschicht vorgesehen ist;
wobei eine Streifenelektrode (12) für einen elektrischen Anschluss an eine äußere Elektrode durch diese Kollektorelektrodenabdeckschicht (23) auf einer oberen Oberfläche der Kollektorelektrode (5) vorgesehen ist;
**dadurch gekennzeichnet, dass**:
ein Bereich der Kollektorelektrodenabdeckschicht (23), der zwischen dieser Streifenelektrode (12) und der Kollektorelektrode (5) liegt, eine Lötschicht (23b) umfasst; und
ein anderer Bereich der Elektrodenabdeckschicht (23), der eine seitliche Oberfläche der Kollektorelektrode (5) bedeckt, eine wärmehärtbare Harzschicht (23a) umfasst.

2. Solarzellenmodul nach Anspruch 1, **dadurch gekennzeichnet, dass** ein Beschichtungsfilm (10) auf dieser photoelektrischen Umwandlungsschicht vorgesehen ist und diese wärmehärtbare Harzschicht (23a) zwischen der Kollektorelektrode (5) und einem Ende dieses Beschichtungsfilms (10) liegt.

3. Solarzellenmodul nach Anspruch 2, **dadurch gekennzeichnet, dass** ein lichtdurchlässiger leitfähiger Film (4) auf der photoelektrischen Umwandlungsschicht vorgesehen ist und der Beschichtungsfilm (10) und die Kollektorelektrode (5) auf dem lichtdurchlässigen leitfähigen Film (4) vorgesehen sind.

4. Solarzellenmodul nach Anspruch 2 oder 3, **dadurch gekennzeichnet, dass** der Beschichtungsfilm (10) ein Harz-Beschichtungsfilm ist.

5. Solarzellenmodul nach irgendeinem der Ansprüche 1-4, **dadurch gekennzeichnet, dass** die Streifenelektrode (12) eine ausreichende Breite aufweist, um die wärmehärtbare Harzschicht (23a) zu bedecken, die außen an dieser lateralen Seite der Kollektorelektrode (5) angeordnet ist.

6. Solarzellenmodul nach irgendeinem der Ansprüche 1-5, **dadurch gekennzeichnet, dass** die Kollektorelektrode (5) eine Sammelschienen-Elektrode (5b) ist.

7. Solarzellenmodul nach irgendeinem der Ansprüche 1-6, **dadurch gekennzeichnet, dass** die Lötschicht (23b) aus einer SnBi-Legierung gebildet ist.

8. Verfahren zum Herstellen des Solarzellenmoduls nach irgendeinem der Ansprüche 1-7, **dadurch gekennzeichnet, dass** es die folgenden Schritte umfasst:
Auftragen einer wärmehärtbaren leitfähigen Lötpaste auf die Kollektorelektrode (5), um eine Lötpastenschicht auszubilden;
Bereitstellen der Streifenelektrode (12) auf dieser Lötpastenschicht; und
Erhitzen der Lötpastenschicht, während die Streifenelektrode (12) darauf angeordnet ist, so dass eine in der Lötpastenschicht enthaltene Lötkomponente schmilzt, um die Lötschicht (23b) zwischen der Streifenelektrode (12) und der Kollektorelektrode (5) auszubilden, und so dass ein in der Lötpastenschicht enthaltenes wärmehärtbares Harz die wärmehärtbare Harzschicht (23a) in einem Bereich auf der lateralen Oberfläche der Kollektorelektrode (5) ausbildet, wobei die Lötschicht (23b) und die wärmehärtbare Harzschicht (23a) die Kollektorelektrodenabdeckschicht (23) auf der Oberfläche der Kollektorelektrode (5) bilden.

9. Verfahren zum Herstellen des Solarzellenmoduls nach Anspruch 8, **dadurch gekennzeichnet, dass** es ferner den Schritt umfasst:
Ausbilden des Beschichtungsfilms (10) auf der photoelektrischen Umwandlungsschicht, wobei der Beschichtungsfilm (10) das wärmehärtbare Harz am Benetzen und Ausbreiten hindert, wenn die Lötpastenschicht erhitzt wird, um die wärmehärtbare Harzschicht (23a) zu bilden, so dass die wärmehärtbare Harzschicht (23a) zwischen der Kollektorelektrode (5) und dem Ende des Beschichtungsfilms (10) liegt.

10. Verfahren zum Herstellen des Solarzellenmoduls nach Anspruch 9, **dadurch gekennzeichnet, dass** es ferner den Schritt umfasst:
Ausbilden des lichtdurchlässigen leitfähigen Films (4) auf der photoelektrischen Umwandlungsschicht, wobei der Schritt zum Ausbilden des Beschichtungsfilms (10) dem Schritt zum Ausbilden des Beschichtungsfilms (10) auf dem lichtdurchlässigen leitfähigen Film (4) entspricht.

## Revendications

1. Module de cellules solaires comprenant une pluralité d'éléments photovoltaïques (11) connectés l'un à l'autre par une électrode formant patte, chacun desdits éléments photovoltaïque (11) comprenant une couche de conversion photoélectrique et une électrode collectrice (5) placée sur au moins une surface de la couche de conversion photoélectrique, dans lequel élément photovoltaïque (11) une couche de recouvrement d'électrode collectrice (23) est placée pour couvrir une surface de l'électrode collectrice (5) placée sur ladite au moins une surface de la couche de conversion photoélectrique; une électrode formant patte (12) servant à établir une connexion électrique à une électrode extérieure est placée, avec intercalation de ladite couche de recouvrement d'électrode collectrice (23), sur une surface supérieure de l'électrode collectrice (5); **caractérisé en ce qu'**une partie de la couche de recouvrement d'électrode collectrice (23) qui se trouve entre ladite électrode formant patte (12) et l'électrode collectrice (5) comprend une couche de brasure (23b); et une autre partie de la couche de recouvrement d'électrode collectrice (23) qui couvre une surface latérale de l'électrode collectrice (5) comprend une couche de résine thermodurcissable (23a).

2. Module de cellules solaires selon la revendication 1, **caractérisé en ce qu'**un film de revêtement (10) est placé sur ladite couche de conversion photoélectrique, et ladite couche de résine thermodurcissable (23a) se trouve entre l'électrode collectrice (5) et une extrémité dudit film de revêtement (10).

3. Module de cellules solaires selon la revendication 2, **caractérisé en ce qu'**un film conducteur translucide (4) est placé sur la couche de conversion photoélectrique, et le film de revêtement (10) et l'électrode collectrice (5) sont placés sur ledit film conducteur translucide (4).

4. Module de cellules solaires selon la revendication 2 ou 3, **caractérisé en ce que** le film de revêtement (10) est un film de revêtement en résine.

5. Module de cellules solaires selon l'une quelconque des revendications 1-4, **caractérisé en ce que** l'électrode formant patte (12) a une largeur suffisante pour couvrir la couche de résine thermodurcissable (23a) située à l'extérieur dudit côté latéral de l'électrode collectrice (5).

6. Module de cellules solaires selon l'une quelconque des revendications 1-5, **caractérisé en ce que** l'électrode collectrice (5) est une électrode de barre omnibus (5b).

7. Module de cellules solaires selon l'une quelconque des revendications 1-6, **caractérisé en ce que** la couche de brasure (23b) est faite d'un alliage SnBi.

8. Procédé de fabrication du module de cellules solaires de l'une quelconque des revendications 1-7, **caractérisé en ce qu'**il comprend les étapes de: application d'une pâte à braser conductrice thermodurcissable sur l'électrode collectrice (5) pour former une couche de pâte à braser; placement de l'électrode formant patte (12) sur ladite couche de pâte à braser; et chauffage de la couche de pâte à braser pendant que l'électrode formant patte (12) est placée sur elle de telle manière qu'un composant de brasure contenu dans la couche de pâte à braser fonde pour former la couche de brasure (23b) entre l'électrode formant patte (12) et l'électrode collectrice (5) et qu'une résine thermodurcissable contenue dans la couche de pâte à braser forme la couche de résine thermodurcissable (23a) dans une région située sur la surface latérale de l'électrode collectrice (5), ce par quoi la couche de brasure (23b) et la couche de résine thermodurcissable (23a) constituent la couche de recouvrement d'électrode collectrice (23) sur la surface de l'électrode collectrice (5).

9. Procédé de fabrication du module de cellules solaires selon la revendication 8, **caractérisé en ce qu'**il comprend en outre l'étape de formation du film de revêtement (10) sur la couche de conversion photoélectrique, ce par quoi lorsque la couche de pâte à braser est chauffée pour former la couche de résine thermodurcissable (23a), le film de revêtement (10) empêche la résine thermodurcissable de mouiller et s'étaler de telle manière que la couche de résine thermodurcissable (23a) se trouve entre l'électrode collectrice (5) et l'extrémité du film de revêtement (10).

10. Procédé de fabrication du module de cellules solaires selon la revendication 9, **caractérisé en ce qu'**il comprend en outre l'étape de formation du film conducteur translucide (4) sur la couche de conversion photoélectrique, et **en ce que** l'étape de formation du film de revêtement (10) est l'étape consistant à former le film de revêtement (10) sur le film conducteur translucide (4).
